# EUROPEAN PATENT APPLICATION

(11) **EP 4 376 098 A1**
(43) Date of publication of application: **29.05.2024**
(21) Application number: 23192370.7
(22) Date of filing: 21.08.2023
(51) Int. Cl.: H01L 31/0224, H10K 102/10

(54) **SOLAR CELL, SOLAR CELL MODULE, AND SOLAR CELL POWER GENERATION SYSTEM**

(30) Priority: 25.11.2022 JP 2022188305
(71) Applicant: KABUSHIKI KAISHA TOSHIBA, Minato-ku Tokyo 105-0023 (JP)
(72) Inventor: WADA, Atsushi, Tokyo, 105-0023 (JP); AMANO, Akio, Tokyo, 105-0023 (JP); AIGA, Fumihiko, Tokyo, 105-0023 (JP); TAKASU, Isao, Tokyo, 105-0023 (JP)
(74) Representative: Hoffmann Eitle

(57) **Abstract**

According to one embodiment, a solar cell (110) includes a first electrode (10), a second electrode (20), and a power generation layer (30) provided between the first electrode and the second electrode. The first electrode includes a first region (11) and a second region (12). A direction from the first region to the second region is along a first direction from the first electrode to the second electrode. A first absorption coefficient of the first region for a first light having a wavelength of 330 nm is lower than a second absorption coefficient of the second region for the first light.

## Description

### FIELD

Embodiments of the invention generally relate to a solar cell, a solar cell module, and a solar cell power generation system.

### BACKGROUND

For example, in solar cells, stable characteristics are desired.

### BRIEF DESCRIPTION OF THE DRAWINGS

FIG. 1 is a schematic cross-sectional view illustrating a solar cell according to a first embodiment;
FIG. 2 is a graph illustrating characteristics of a solar cell;
FIG. 3 is a graph illustrating characteristics of a solar cell;
FIG. 4 is a schematic cross-sectional view illustrating a solar cell according to the first embodiment;
FIG. 5 is a schematic cross-sectional view illustrating the solar cell according to the first embodiment;
FIG. 6 is a schematic cross-sectional view illustrating a solar cell module according to a second embodiment; and
FIG. 7 is a schematic cross-sectional view illustrating a solar cell module according to the second embodiment.

### DETAILED DESCRIPTION

According to one embodiment, a solar cell includes a first electrode, a second electrode, and a power generation layer provided between the first electrode and the second electrode. The first electrode includes a first region and a second region. A direction from the first region to the second region is along a first direction from the first electrode to the second electrode. A first absorption coefficient of the first region for a first light having a wavelength of 330 nm is lower than a second absorption coefficient of the second region for the first light.

Various embodiments are described below with reference to the accompanying drawings.

The drawings are schematic and conceptual; and the relationships between the thickness and width of portions, the proportions of sizes among portions, etc., are not necessarily the same as the actual values. The dimensions and proportions may be illustrated differently among drawings, even for identical portions.

In the specification and drawings, components similar to those described previously in an antecedent drawing are marked with like reference numerals, and a detailed description is omitted as appropriate.

### First Embodiment

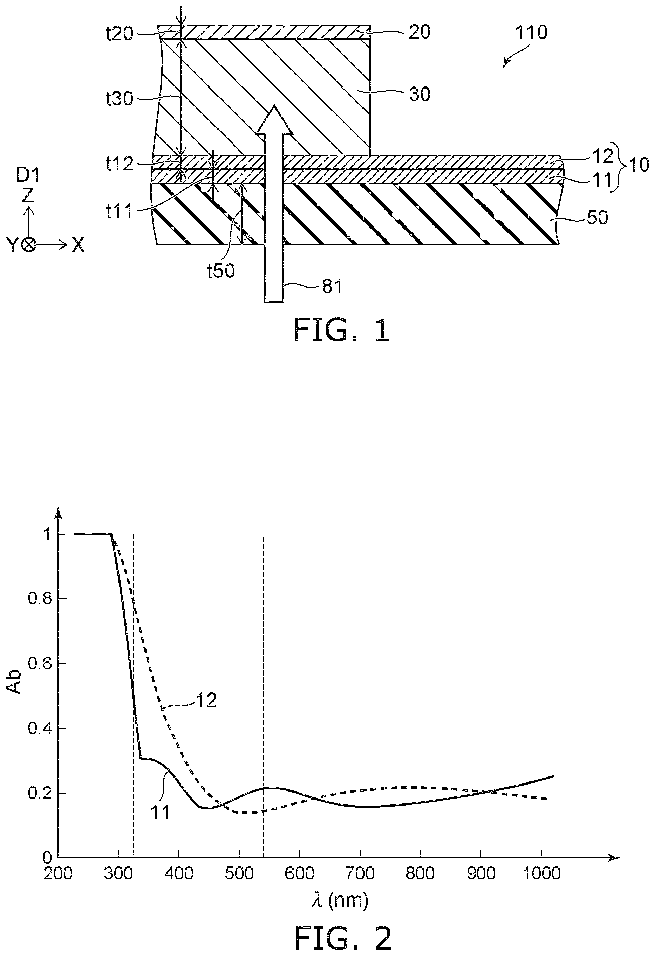

FIG. 1 is a schematic cross-sectional view illustrating a solar cell according to a first embodiment.

As shown in FIG. 1, a solar cell 110 according to the embodiment includes a first electrode 10, a second electrode 20 and a power generation layer 30. The power generation layer 30 is provided between the first electrode 10 and the second electrode 20. The first electrode 10 includes a first region 11 and a second region 12. A direction from the first region 11 to the second region 12 is along a first direction D1 from the first electrode 10 to the second electrode 20. The boundary between the first region 11 and the second region 12 may be clear or unclear.

The first direction D1 is defined as a Z-axis direction. One direction perpendicular to the Z-axis direction is defined as an X-axis direction. A direction perpendicular to the Z-axis direction and the X-axis direction is defined as a Y-axis direction.

The first electrode 10 and the second electrode 20 are, for example, layered along the X-Y plane. The first region 11 and the second region 12 are layered along the X-Y plane.

In this example, the second region 12 is provided between the first region 11 and the power generation layer 30. In embodiments, the first region 11 may be provided between the second region 12 and the power generation layer 30. An example in which the second region 12 is provided between the first region 11 and the power generation layer 30 will be described below.

As shown in FIG. 1, the solar cell 110 may include base 50. The base 50 is light transmissive. The first electrode 10 is provided between the base 50 and the power generation layer 30. The base 50 may be a resin substrate or a glass substrate. The base 50 may be a resin film.

As shown in FIG. 1, light 81 is incident on the solar cell 110. The light 81 passes through the first electrode 10 and enters the power generation layer 30. In this example, the light 81 passes through the base 50 and the first electrode 10 and enters the power generation layer 30. Carriers are generated in the power generation layer 30 based on the light 81. Electric power is obtained by extracting carriers through the first electrode 10 and the second electrode 20. The light 81 is, for example, sunlight.

In the embodiment, the optical properties of the first region 11 are different from the optical properties of the second region 12. For example, the absorptance for ultraviolet rays of the second region 12 is higher than the absorptance for ultraviolet rays of the first region 11.

In the embodiment, for example, the absorption coefficient (first absorption coefficient) of the first region 11 for a first light with a wavelength of 330 nm is lower than the absorption coefficient (second absorption coefficient) of the second region 12 for the first light. For example, the second region 12 can efficiently absorb the first light (ultraviolet rays).

When the light 81 enters the second region 12, the first light (ultraviolet light) included in the light 81 can be suppressed from entering the power generation layer 30. Thereby, in the power generation layer 30, deterioration due to ultraviolet rays can be suppressed. According to the embodiments, it is possible to provide a solar cell capable of obtaining stable characteristics.

The light 81 may include components (e.g., visible light) other than ultraviolet rays. In the embodiment, visible light is preferably efficiently transmitted through the first electrode 10. Thereby, highly efficient power generation can be possible. For example, the transmittance for visible light of the first electrode 10 is high. For example, the first electrode 10 has a low absorptance for visible light.

For example, in a case where the absorption coefficient for ultraviolet light in the second region 12 is higher than the absorption coefficient for ultraviolet light in the first region 11, the absorption coefficient for visible light in the second region 12 may be higher than the absorption coefficient for visible light in the first region 11. The wavelength characteristics of the absorption coefficient (absorptance) may be different between the first region 11 and the second region 12. Thereby, for example, it is easy to obtain a high absorption coefficient for ultraviolet rays.

For example, the absorption coefficient (third absorption coefficient) of the first region 11 for the second light with a wavelength of 540 nm may be higher than the absorption coefficient (fourth absorption coefficient) of the second region 12 for the second light.

The absorptance of the first region 11 with respect to the first light (ultraviolet rays) may be higher than the absorptance of the second region 12 with respect to the first light. The absorptance of the first region 11 for the second light (visible light) may be higher than the absorptance of the second region 12 for the second light. For example, it is easy to obtain a low absorptance for visible light in the second region 12 while obtaining a high absorptance for ultraviolet rays in the second region 12.

The first electrode 10 may include a metal oxide. By changing the composition of the metal oxide, the absorption coefficient for ultraviolet rays can be controlled.

In one example, the first region 11 and the second region 12 include a first material. The first material includes tin, indium and oxygen. The first material includes, for example, ITO (Indium Tin Oxide). The first region 11 and the second region 12 satisfy at least one of a first condition or a second condition. In the first condition, the tin concentration in the second region 12 is lower than the tin concentration in the first region 11. In the second condition, the oxygen concentration in the second region 12 is higher than the oxygen concentration in the first region 11. For example, a high carrier density is easily obtained due to oxygen deficiency.

In another example, the first region 11 and the second region 12 include a second material. The second material includes aluminum, zinc and oxygen. The second material is, for example, AZO. The first region 11 and the second region 12 satisfy at least one of a third condition or a fourth condition. In the third condition, the aluminum concentration in the second region 12 is lower than the aluminum concentration in the first region 11. In the fourth condition, the oxygen concentration in the second region 12 is higher than the oxygen concentration in the first region 11. For example, a high carrier density is easily obtained due to oxygen deficiency.

In another example, the first region 11 and the second region 12 include a third material. The third material includes gallium, zinc and oxygen. The third material is GZO, for example. The first region 11 and the second region 12 satisfy at least one of a fifth condition or a sixth condition. In the fifth condition, the gallium concentration in the second region 12 is lower than the gallium concentration in the first region 11. In the sixth condition, the oxygen concentration in the second region 12 is higher than the oxygen concentration in the first region 11. For example, a high carrier density is easily obtained due to oxygen deficiency.

By such a difference, for example, the absorption coefficient for ultraviolet rays in the second region 12 can be made higher than the absorption coefficient for ultraviolet rays in the first region 11.

In a case where the first electrode 10 includes the above materials, if a high absorption coefficient for ultraviolet rays is tried to obtain, the electrical resistance tends to increase. On the other hand, in a case where the absorption coefficient for ultraviolet rays is low, it is easy to obtain low electrical resistance. For example, the second region 12 having a high absorption coefficient for ultraviolet rays and the first region 11 having a low electrical resistance are stacked. As a result, the first electrode 10 can effectively absorb ultraviolet light and have a low electrical resistance.

For example, in the embodiment, a first carrier density in the first region 11 is higher than a second carrier density in the second region 12.

For example, in the embodiment, a first resistivity in the first region 11 is lower than a second resistivity in the second region 12.

By changing the composition of the material of the conductive compound in the first electrode 10 as described above, a high absorption coefficient for ultraviolet rays and a low electrical resistivity can be obtained.

In the embodiment, for example, an absolute value of a difference between the first absorption coefficient in the first region 11 and the second absorption coefficient in the second region 12 is 1.0×10⁵ cm⁻¹ or more.

In the embodiment, the first electrode 10 is a light transmissive conductive film. The second electrode 20 is, for example, a light-reflective conductive film. The light transmittance of the second electrode 20 is lower than the light transmittance of the first electrode 10. The light reflectance of the second electrode 20 is higher than the light reflectance of the first electrode 10.

For example, the transmittance of the second electrode 20 to a third light (for example, light 81) having a center wavelength of 540 nm is lower than the transmittance of the first region 11 to the third light and lower than the transmittance of the second region 12 to the third light.

For example, the second electrode 20 includes at least one selected from the group consisting of Al, Ag and Ti. The second electrode 20 may be, for example, a metal reflective film.

As shown in FIG. 1, the light 81 passes through the first electrode 10 and enters the power generation layer 30. Electric power is generated between the first electrode 10 and the second electrode 20 according to the light 81 that has passed through the first electrode 10 and entered the power generation layer 30.

In the embodiment, at least a part of the power generation layer 30 includes a perovskite crystal material (e.g., lead methylammonium iodide: MAPbI₃, etc.). High power generation efficiency can be obtained. When ultraviolet rays are incident on the perovskite crystal material, the perovskite crystal material is likely to deteriorate. In the embodiment, the second region 12 is provided having a high absorptance for UV radiation. Thereby, the deterioration is suppressed even when at least part of the power generation layer 30 includes a perovskite crystal material. Stable characteristics can be obtained.

Information on absorption coefficients, absorptance or transmittance can be obtained, for example, by ellipsometry. Information on carrier density can be obtained, for example, by Hall effect measurements. Information on electrical resistivity is obtained by four-terminal resistance measurements.

As shown in FIG. 1, a thickness of the first region 11 along the first direction D1 is defined as a first thickness t11. The first thickness t11 is, for example, not less than 1 nm and not more than 200 nm. A thickness of the second region 12 along the first direction D1 is defined as a second thickness t12. The second thickness t12 is not less than 1 nm and not more than 200 nm.

In the embodiment, a thickness t20 of the second electrode 20 along the first direction D1 is, for example, not less than 10 nm and not more than 500 nm. A thickness t30 of the power generation layer 30 along the first direction D1 is, for example, not less than 100 nm and not more than 1500 nm. A thickness t50 of the base 50 along the first direction D1 is, for example, not less than 30 µm and not more than 1000 µm.

The first electrode 10 (first region 11 and second region 12) may be formed, for example, by sputtering using targets of different compositions. The first electrode 10 (the first region 11 and the second region 12) may be formed by vapor deposition, for example.

FIG. 2 is a graph illustrating characteristics of a solar cell.

FIG. 2. illustrate optical properties of the first region 11 and the second region 12. The horizontal axis of FIG. 2 is wavelength λ. The vertical axis is the absorptance Ab. In the example of FIG. 2, the respective thicknesses of the first region 11 and the second region 12 are the same as each other. Therefore, the absorption Ab corresponds to the absorption coefficient. In the example of FIG. 2, the first region 11 and the second region 12 include indium, tin and oxygen. The composition differs between the first region 11 and the second region 12.

As shown in FIG. 2, the absorptance Ab (i.e., the first absorption coefficient) of the first region 11 with respect to the first light having the wavelength of 330 nm is lower than the absorptance Ab (i.e., the second absorption coefficient) of the second region 12 with respect to the first light. The absorptance Ab (i.e., the third absorption coefficient) of the first region 11 with respect to the second light having the wavelength of 540 nm is higher than the absorptance Ab (i.e., the fourth absorption coefficient) of the second region 12 with respect to the second light.

In the example of FIG. 2, the electrical resistivity in the first region 11 is approximately 1.5 × 10⁻⁴ Ωcm. The electrical resistivity in the second region 12 is approximately 5.0 × 10⁻⁴ Ωcm.

In the example of FIG. 2, the carrier density in the first region 11 is approximately 1.0 × 10²¹ cm⁻³. The carrier density in the second region 12 is approximately 3.7 × 10²⁰ cm⁻³.

In the example of FIG. 2, the work function in the first region 11 is approximately 5.0 eV. The work function in the second region 12 is approximately 5.1 eV. In embodiments, for example, the work function of the second region 12 is greater than the work function of the first region 11. In this case, the second region 12 having a large work function is preferably provided between the first region 11 and the power generation layer 30. As a result, carriers generated in the power generation layer 30 can be extracted with higher efficiency.

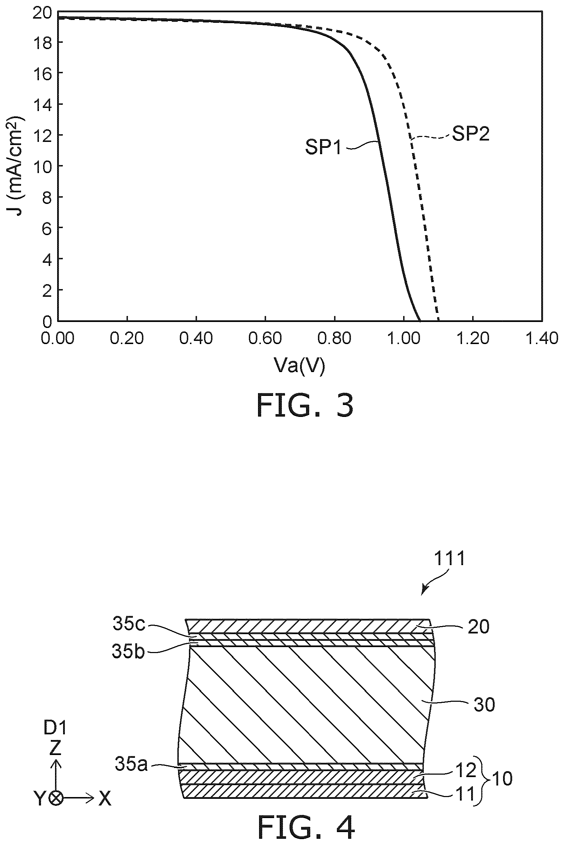

FIG. 3 is a graph illustrating characteristics of a solar cell.

FIG. 3 illustrates simulation results of the power generation characteristics of a first sample SP1 and a second sample SP2. In these samples, the first electrode 10 is one type material. In the first sample SP1, the first electrode 10 is a material (having a work function of 5.0 eV) corresponding to the first region 11. In the second sample SP2, the first electrode 10 is a material (having a work function of 5.1 eV) corresponding to the second region 12. The horizontal axis of FIG. 3 is a voltage Va between the first electrode 10 and the second electrode 20. The vertical axis is the current density J.

As shown in FIG. 3, the second sample SP2 has higher power generation efficiency than the first sample SP1.

In the embodiment, the first region 11 having a low absorption coefficient for ultraviolet rays (for example, wavelength of 330 nm) may be provided between the second region 12 and the power generation layer 30. In this case, it becomes easier to take out the current.

FIG. 4 is a schematic cross-sectional view illustrating a solar cell according to the first embodiment.

As shown in FIG. 4, a solar cell 111 according to the embodiment includes a first intermediate layer 35a. The first intermediate layer 35 a is provided between the first electrode 10 and the power generation layer 30. The first intermediate layer 35a is, for example, a hole transport layer. The first intermediate layer 35a includes, for example, poly[bis(4-phenyl)(2,4,6-triphenylmethyl)amine]. The thickness of the first intermediate layer 35a is, for example, not less than 1 nm and not more than 50 nm (e.g., 5 nm).

The solar cell 111 may further include a second intermediate layer 35b. The second intermediate layer 35b is provided between the power generation layer 30 and the second electrode 20. The second intermediate layer 35b may include, for example, PCBM (e.g., [6,6]-Phenyl-C61-Butyric Acid Methyl Ester). The thickness of the second intermediate layer 35b is, for example, not less than 1 nm and not more than 100 nm (e.g., 50 nm).

The solar cell 111 may further include a third intermediate layer 35c. The third intermediate layer 35c is provided between the power generation layer 30 and the second electrode 20. In this example, the third intermediate layer 35c is provided between the second intermediate layer 35b and the second electrode 20. The third intermediate layer 35c may include, for example, NBPhen (e.g., [2,9-bis(naphthalen-2-yl)-4,7-diphenyl-1,10-phenanthroline]). The thickness of the third intermediate layer 35c is, for example, not less than 1 nm and not more than 50 nm (e.g., 2 nm).

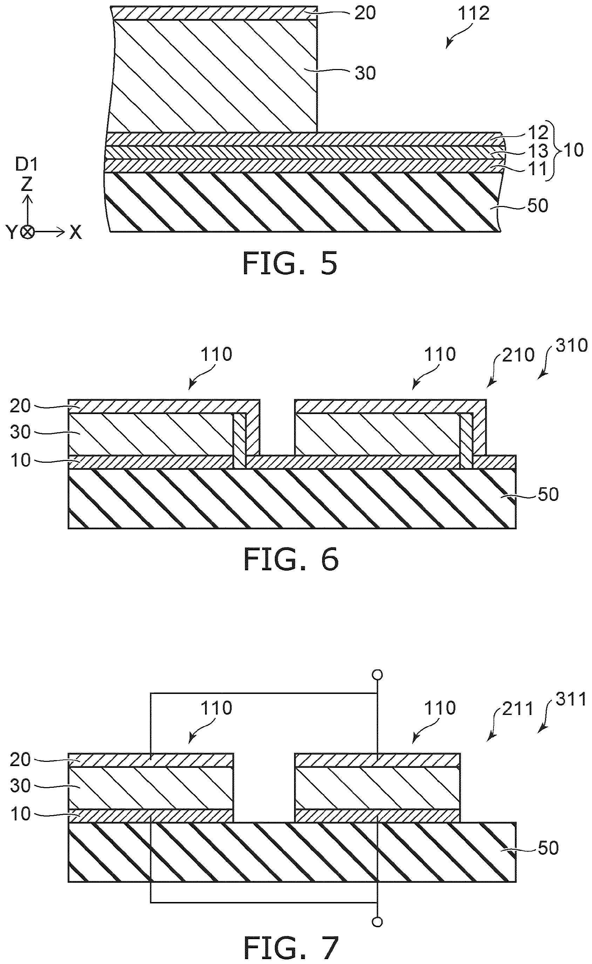

FIG. 5 is a schematic cross-sectional view illustrating the solar cell according to the first embodiment.

As shown in FIG. 5 , in a solar cell 112 according to the embodiment, the first electrode 10 further includes a third region 13. The third region 13 is provided between the first region 11 and the second region 12. The optical properties, electrical properties and composition in the third region 13 may be between those properties in the first region 11 and those properties in the second region 12. The third region 13 is, for example, a transition region.

The boundary between the first region 11 and the second region 12 may be unclear. This suppresses the influence caused by the reflection at the interfaces of these regions. For example, the absorption coefficient at the first electrode 10 may change continuously between the first region 11 and the second region 12.

### Second Embodiment

FIG. 6 is a schematic cross-sectional view illustrating a solar cell module according to a second embodiment.

As shown in FIG. 6, a solar cell module 210 according to the embodiment includes a plurality of solar cells (for example, solar cells 110) according to the embodiment. At least two of the plurality of solar cells 110 are electrically connected in series or in parallel. In the example of FIG. 6, one of the plurality of solar cells 110 is electrically connected in series with another one of the plurality of solar cells 110. A desired voltage is obtained.

FIG. 7 is a schematic cross-sectional view illustrating a solar cell module according to the second embodiment.

As shown in FIG. 7, a solar cell module 211 according to the embodiment includes a plurality of solar cells (for example, solar cells 110) according to the embodiment. In the solar cell module 211 , one of the solar cells 110 is electrically connected in parallel with another one of the solar cells 110. A desired current is obtained.

The embodiments may include a solar cell power generation system 310 or a solar cell power generation system 311 (see FIGS. 6 and 7). The solar cell power generation system 310 includes the solar cell module 210 according to the embodiment. The solar cell power generation system 311 includes the solar cell module 211 according to the embodiment.

The embodiments may include the following configurations (for example, technical proposals).

### Configuration 1

A solar cell, comprising:
a first electrode;
a second electrode; and
a power generation layer provided between the first electrode and the second electrode,
the first electrode including a first region and a second region,
a direction from the first region to the second region being along a first direction from the first electrode to the second electrode, and
a first absorption coefficient of the first region for a first light having a wavelength of 330 nm being lower than a second absorption coefficient of the second region for the first light.

### Configuration 2

The solar cell according to Configuration 1, wherein
a third absorption coefficient of the first region for a second light having a wavelength of 540 nm is higher than a fourth absorption coefficient of the second region for the second light.

### Configuration 3

The solar cell according to Configuration 2, wherein
an absorptance of the first region for the second light is higher than an absorptance of the second region for the second light.

### Configuration 4

The solar cell according to any one of Configurations 1-3, wherein
an absorptance of the first region for the first light is higher than the absorptance of the second region for the first light.

### Configuration 5

The solar cell according to any one of Configurations 1-4, wherein
the first region and the second region include a first material including tin, indium and oxygen,
the first region and the second region satisfy at least one of a first condition or a second condition,
in the first condition, a concentration of tin in the second region is lower than a concentration of tin in the first region, and
in the second condition, a concentration of oxygen in the second region is higher than a concentration of oxygen in the first region.

### Configuration 6

The solar cell according to any one of Configurations 1-4, wherein
the first region and the second region include a second material including aluminum, zinc and oxygen,
the first region and the second region satisfy at least one of the third condition or the fourth condition,
in the third condition, a concentration of aluminum in the second region is lower than a concentration of aluminum in the first region, and
in the fourth condition, a concentration of oxygen in the second region is higher than a concentration of oxygen in the first region.

### Configuration 7

The solar cell according to any one of Configurations 1-6, wherein
an absolute value of a difference between the first absorption coefficient and the second absorption coefficient is 1.0 × 10 cm⁻¹ or more.

### Configuration 8

The solar cell according to Configuration 5 or 6, wherein
the second region is provided between the first region and the power generation layer.

### Configuration 9

The solar cell according to Configuration 8, wherein
a work function of the second region is greater than a work function of the first region.

### Configuration 10

The solar cell according to any one of Configurations 1-9, wherein
at least part of the power generation layer includes a perovskite crystal material.

### Configuration 11

The solar cell according to any one of Configurations 1-10, wherein
a first thickness of the first region along the first direction is not less than 1 nm and not more than 200, and
a second thickness of the second region along the first direction is not less than 1 nm and not more than 200 nm.

### Configuration 12

The solar cell according to any one of Configurations 1-11, wherein
a transmittance of the second electrode to a third light having a center wavelength of 540 nm is lower than a transmittance of the first region to the third light and lower than a transmittance of the second region to the third light.

### Configuration 13

The solar cell according to any one of Configurations 1-12, wherein
the second electrode includes at least one selected from the group consisting of Al, Ag and Ti.

### Configuration 14

The solar cell according to any one of Configurations 1-13, wherein
electric power is generated between the first electrode and the second electrode according to a light that has passed through the first electrode and entered the power generation layer.

### Configuration 15

The solar cell according to any one of Configurations 1-14, wherein
a first carrier density in the first region is higher than a second carrier density in the second region.

### Configuration 16

The solar cell according to any one of Configurations 1-15, wherein
a first resistivity in the first region is lower than a second resistivity in the second region.

### Configuration 17

The solar cell according to any one of Configurations 1-16, wherein
an absorption coefficient in the first electrode changes continuously between the first region and the second region.

### Configuration 18

The solar cell according to any one of Configurations 1-17, further comprising:
a base being light transmissive,
the first electrode being provided between the base and the power generation layer.

Configuration 19

A solar cell module, comprising:
a plurality of the solar cells according to any one of Configurations 1-18,
at least two of the plurality of solar cells being electrically connected in series or in parallel.

### Configuration 20

A solar cell power generation system, comprising:
the solar cell module according to Configuration 19.

According to the embodiments, a solar cell, a solar cell module, and a solar cell power generation system capable of obtaining stable characteristics are provided.

Hereinabove, exemplary embodiments of the invention are described with reference to specific examples. However, the embodiments of the invention are not limited to these specific examples. For example, one skilled in the art may similarly practice the invention by appropriately selecting specific configurations of components included in solar cells such as electrodes, power generation layers, base, etc., from known art. Such practice is included in the scope of the invention to the extent that similar effects thereto are obtained.

Further, any two or more components of the specific examples may be combined within the extent of technical feasibility and are included in the scope of the invention to the extent that the purport of the invention is included.

Moreover, all solar cells, solar cell modules, and solar cell power generation systems practicable by an appropriate design modification by one skilled in the art based on the solar cells, solar cell modules, and solar cell power generation systems described above as embodiments of the invention also are within the scope of the invention to the extent that the purport of the invention is included.

Various other variations and modifications can be conceived by those skilled in the art within the spirit of the invention, and it is understood that such variations and modifications are also encompassed within the scope of the invention.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

## Claims

1. A solar cell, comprising:
a first electrode;
a second electrode; and
a power generation layer provided between the first electrode and the second electrode,
the first electrode including a first region and a second region,
a direction from the first region to the second region being along a first direction from the first electrode to the second electrode, and
a first absorption coefficient of the first region for a first light having a wavelength of 330 nm being lower than a second absorption coefficient of the second region for the first light.

2. The cell according to claim 1, wherein
a third absorption coefficient of the first region for a second light having a wavelength of 540 nm is higher than a fourth absorption coefficient of the second region for the second light.

3. The cell according to claim 2, wherein
an absorptance of the first region for the second light is higher than an absorptance of the second region for the second light.

4. The cell according to any one of claims 1-3, wherein
an absorptance of the first region for the first light is higher than the absorptance of the second region for the first light.

5. The cell according to any one of claims 1-4, wherein
the first region and the second region include a first material including tin, indium and oxygen,
the first region and the second region satisfy at least one of a first condition or a second condition,
in the first condition, a concentration of tin in the second region is lower than a concentration of tin in the first region, and
in the second condition, a concentration of oxygen in the second region is higher than a concentration of oxygen in the first region.

6. The cell according to any one of claims 1-4, wherein
the first region and the second region include a second material including aluminum, zinc and oxygen,
the first region and the second region satisfy at least one of the third condition or the fourth condition,
in the third condition, a concentration of aluminum in the second region is lower than a concentration of aluminum in the first region, and
in the fourth condition, a concentration of oxygen in the second region is higher than a concentration of oxygen in the first region.

7. The cell according to claim 5, wherein
the second region is provided between the first region and the power generation layer.

8. The cell according to any one of claims 1-7, wherein
at least part of the power generation layer includes a perovskite crystal material.

9. The cell according to any one of claims 1-8, wherein
a transmittance of the second electrode to a third light having a center wavelength of 540 nm is lower than a transmittance of the first region to the third light and lower than a transmittance of the second region to the third light.

10. The cell according to any one of claims 1-9, wherein
electric power is generated between the first electrode and the second electrode according to a light that has passed through the first electrode and entered the power generation layer.

11. The cell according to any one of claims 1-10, wherein
a first resistivity in the first region is lower than a second resistivity in the second region.

12. The cell according to any one of claims 1-11, wherein
an absorption coefficient in the first electrode changes continuously between the first region and the second region.

13. The cell according to any one of claims 1-12, further comprising:
a base being light transmissive,
the first electrode being provided between the base and the power generation layer.

14. A solar cell module, comprising:
a plurality of the solar cells according to any one of claims 1-13,
at least two of the plurality of solar cells being electrically connected in series or in parallel.

15. A solar cell power generation system, comprising: the solar cell module according to claim 14.
